(19) Europäisches Patentamt
European Patent Office
Office européen des brevets

(11) **EP 2 856 642 B1**

(12) **EUROPÄISCHE PATENTSCHRIFT**

(45) Veröffentlichungstag und Bekanntmachung des Hinweises auf die Patenterteilung:
**14.06.2017 Patentblatt 2017/24**

(21) Anmeldenummer: **13724516.3**

(22) Anmeldetag: **03.05.2013**

(51) Int Cl.:
**H03F 3/217** *(2006.01)* **H03F 1/30** *(2006.01)*

(86) Internationale Anmeldenummer:
**PCT/EP2013/001323**

(87) Internationale Veröffentlichungsnummer:
**WO 2013/174476 (28.11.2013 Gazette 2013/48)**

(54) **GESCHALTETER VERSTÄRKER FÜR VARIABLE VERSORGUNGSSPANNUNG**

SWITCHED AMPLIFIER FOR VARIABLE SUPPLY VOLTAGE

AMPLIFICATEUR COMMUTÉ DESTINÉ À UNE TENSION D'ALIMENTATION VARIABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **24.05.2012 DE 102012104488**

(43) Veröffentlichungstag der Anmeldung:
**08.04.2015 Patentblatt 2015/15**

(73) Patentinhaber: **Hochschule für angewandte Wissenschaften München
80335 München (DE)**

(72) Erfinder: **KLUGBAUER-HEILMEIER, Josef
85356 Freising (DE)**

(74) Vertreter: **Lucke, Andreas
Boehmert & Boehmert
Anwaltspartnerschaft mbB
Patentanwälte Rechtsanwälte
Pettenkoferstrasse 20-22
80336 München (DE)**

(56) Entgegenhaltungen:
**EP-A1- 0 184 280     EP-A1- 0 503 571
WO-A1-00/42702      WO-A2-2004/023631
WO-A2-2004/023645   US-A1- 2005 200 404
US-A1- 2007 152 750  US-A1- 2009 027 117
US-A1- 2009 091 382  US-B1- 6 741 123**

**Beschreibung**

GEBIET DER ERFINDUNG

Die vorliegende Erfindung liegt auf dem Gebiet der Audiotechnik. Genauer betrifft sie einen geschalteten Verstärker, der für einen energieeffizienten Betrieb geeignet ist, sowie ein Verfahren zur energieeffizienten Verstärkung von Audiosignalen.

VERWANDTER STAND DER TECHNIK

Zur Verstärkung von Audiosignalen werden in der Audiotechnik elektronische Leistungsverstärker eingesetzt. Die verstärkten Audiosignale werden mithilfe eines Lautsprechers in ein Schallsignal umgewandelt, welches dann vom Nutzer wahrgenommen werden kann. Solche elektronischen Leistungsverstärker werden in üblichen Geräten der Konsumelektronik, wie beispielsweise in CD-Playern und Fernsehgeräten verwendet.

Eine weit verbreitete Klasse von Verstärkern sind sogenannte Class-D Verstärker, die einen Modulator und eine geschaltete Schaltendstufe umfassen. Solche Class-D Verstärker zeichnen sich dadurch aus, dass die Schaltendstufe Schalter enthält, die nur zwei diskrete Schaltzustände annehmen und nicht - wie es bei anderen Verstärkerarten üblich ist - kontinuierlich ausgesteuert werden. Dadurch weisen diese geschalteten Verstärker einen vergleichsweise hohen Wirkungsgrad auf. Aufgrund ihres hohen Wirkungsgrades werden geschaltete Verstärker besonders im professionellen Bereich verwendet, in dem oft höhere Leistungen gefordert werden. Ein Beispiel sind elektroakustische Anlagen, wie sie beispielsweise an Flughäfen oder in Einkaufszentren für Lautsprecherdurchsagen verwendet werden.

Die Ansteuerung der Schalter der Schaltendstufe erfolgt über ein Schaltsignal, welches von dem Modulator in Antwort auf das zu verstärkende Audiosignal bereitgestellt wird. Als Modulationsverfahren für solche Class-D Verstärker wird häufig die Sigma-Delta-Modulation verwendet, mit der aus einem analogen oder digitalen Eingangssignal ein Schaltsignal erzeugt wird, das beispielsweise ein binäres oder ternäres Signal ist.

Ein Beispiel für einen solchen Class-D Verstärker wird in der Patentschrift US 2008/0042746 A1 angegeben. Dieser umfasst einen Sigma-Delta-Modulator, eine Schaltendstufe sowie eine Gegenkopplungsverbindung, mit der Störungen im Signalpfad unterdrückt werden können. Das Ausgangssignal der Schaltendstufe wird dabei aufgrund der Schaltvorgänge in der Schaltendstufe erzeugt. Schaltverluste die sich in der Schaltendstufe ergeben sind dabei proportional zum Quadrat der an der Schaltendstufe anliegenden Versorgungsspannung. Je nach Höhe der anliegenden Versorgungsspannung ergeben sich dabei entsprechend hohe Schaltverluste. Dies wirkt sich besonders bei schwachen Eingangssignalen negativ auf die Energieeffizienz des Verstärkers aus.

Ein weiteres Beispiel für einen Class-D Verstärker wird in der Patentschrift US2006/0091945 A1 angegeben. Dieser Class-D Verstärker arbeitet nach dem Prinzip der Fehlerkorrektur. Dabei werden Fehler, die sich in der Schaltendstufe aufgrund von Fehlern in der Versorgungsspannung ergeben, dadurch minimiert, dass das Signal im Signalpfad außerhalb einer Gegenkopplungsverbindung durch einen digitalen Versorgungsspannungswert dividiert wird.

Ein Beispiel für einen Pulsweitenmodulationsverstärker ist in der EP0503571A1 angegeben. Zur Verstärkung eines Eingangssignals wird ein pulsweitenmoduliertes Signal für einen Leistungsverstärker mit Hilfe eines Komparators erzeugt. Der Komparator empfängt ein dreiecksförmiges Trägersignal, dessen Amplitude von einer Versorgungsspannung abhängig ist.

Aus der US 2007/152750A1 ist ein Verstärker mit einer Kompensation von Variationen einer Leistungsversorgung einer Schaltendstufe bekannt. Unter Berücksichtigung der Leistungsversorgung wird ein Schätzwert für den Gain der Schaltendstufe ermittelt und für eine Signalveränderung auf einer Rückführungsverbindung des Verstärkers verwendet.

ZUSAMMENFASSUNG DER ERFINDUNG

Der vorliegenden Erfindung liegt die Aufgabe zugrunde, einen Verstärker nach dem Oberbegriff des Anspruchs 1 anzugeben, der energieeffizienter arbeiten kann als im Stand der Technik üblich. Weiterhin soll ein Verfahren zur Verfügung gestellt werden, mit dem Audiosignale energieeffizient verstärkt werden können.

Diese Aufgabe wird durch einen Verstärker nach Anspruch 1 und einen Verstärker nach Anspruch 10 sowie durch ein Verfahren nach Anspruch 12 und ein Verfahren nach Anspruch 14 gelöst. Vorteilhafte Weiterbildungen sind in den abhängigen Ansprüchen angegeben.

Der erfindungsgemäße Verstärker dient zur Verstärkung eines Eingangssignals zu einem Ausgangssignal und umfasst einen Signalpfad und eine Gegenkopplungsverbindung. Der Signalpfad

- umfasst Modulationsmittel, die geeignet sind, das Eingangssignal zu empfangen und in Antwort auf das empfangene Eingangssignal ein Schaltsignal zu erzeugen, und

- umfasst eine Schaltendstufe, die mit einer Versorgungsspannung verbunden ist, wobei die Schaltendstufe Schaltmittel enthält, die entsprechend dem von den Modulationsmitteln erzeugten Schaltsignal geschaltet werden, wobei die Schaltendstufe ein Ausgangssignal erzeugt, dessen Amplitude von der Versorgungsspannung abhängt.

Die Gegenkopplungsverbindung ist geeignet, das Ausgangssignal der Schaltendstufe zurückzuführen, um mit dem Eingangssignal kombiniert zu werden. Der Signalpfad und die Gegenkopplungsverbindung bilden eine Schleife mit einer Schleifenverstärkung.

Schließlich umfasst der Verstärker Kompensationsmittel, welche die Versorgungsspannung der Schaltendstufe oder ein aus dieser abgeleitetes Signal empfangen, und die geeignet sind, Änderungen in der Schleifenverstärkung, die sich aufgrund einer Variation der Versorgungsspannung ergeben, zumindest teilweise zu kompensieren.

Bekannte Verstärker, die eine Schaltendstufe, Modulationsmittel und eine Gegenkopplungsverbindung umfassen, werden mit einer konstanten oder im Wesentlichen konstanten Versorgungsspannung betrieben. Auch bei kleinen Amplituden des Eingangssignals liegt die gesamte Versorgungsspannung an der Schaltendstufe an, deren Schaltmittel weiterhin mit einer bestimmten Schaltfrequenz geschaltet werden. Die mittlere Amplitude des Ausgangssignals wird dabei von der Abfolge und dem Vorzeichen der Pulse im Ausgangssignal bestimmt. Die Amplitude der Pulse im Ausgangssignal ist dabei im Wesentlichen konstant und von der Versorgungsspannung abhängig, jedoch unabhängig von der Amplitude des Eingangssignals. Schaltverluste, die sich aus der Schaltung der Schaltmittel ergeben und die quadratisch mit der Versorgungsspannung ansteigen, sind bei bekannten Verstärkern somit im Wesentlichen unabhängig von der Amplitude des Eingangssignals. Somit ergeben sich selbst im Leerlaufbetrieb oder im Standby-Betrieb, d.h. wenn kein Eingangssignal anliegt oder ein Eingangssignal anliegt, dessen Amplitude im Wesentlichen Null entspricht, Schaltverluste, die denjenigen Schaltverlusten entsprechen, die bei Eingangssignalen mit maximaler Amplitude vorliegen. Bei kleinen Amplituden des Eingangssignals sind daher die Effizienzverluste dieser Verstärker relativ hoch.

Wenn bei bekannten geschalteten Verstärkern, die eine Gegenkopplungsverbindung und somit eine Schleife mit einer Schleifenverstärkung umfassen, die Versorgungsspannung variiert wird, kann die Gesamtverstärkung aufgrund der Gegenkopplungsverbindung unter gewissen Umständen im Wesentlichen konstant gehalten werden. Allerdings führt die Veränderung der Versorgungsspannung auch zu einer Veränderung der Schleifenverstärkung, die je nach Betriebszustand des Verstärkers eine Instabilität zur Folge haben kann. Somit können bekannte geschaltete Verstärker nur mit einer im Wesentlichen konstanten Versorgungsspannung stabil betrieben werden.

Im Gegensatz dazu ist der erfindungsgemäße Verstärker für den Betrieb mit einer variablen Versorgungsspannung geeignet, und ist insbesondere für einen energieeffizienteren Betrieb geeignet als er im Stand der Technik üblich ist. Der erfindungsgemäße Verstärker löst die oben genannte Aufgabe mithilfe von Kompensationsmitteln, welche die Versorgungsspannung der Schaltendstufe oder ein aus dieser abgeleitetes Signal empfangen, und die geeignet sind, Änderungen in der Schleifenverstärkung, die sich aufgrund einer Variation der Versorgungsspannung ergeben, zumindest teilweise zu kompensieren.

Aufgrund der Kompensationsmittel wird in dem erfindungsgemäßen Verstärker somit auch bei einer Variation der Versorgungsspannung die Schleifenverstärkung im Wesentlichen konstant gehalten. Dadurch kann der Verstärker unabhängig von der an der Schaltendstufe anliegenden Versorgungsspannung stabil mit hoher Schleifenverstärkung betrieben werden.

Der erfindungsgemäße Verstärker ist damit für den Betrieb mit einer Versorgungsspannung geeignet, die an die Amplitude des Eingangssignals angepasst ist. Beispielsweise kann bei maximalen Eingangssignalen auch die maximale Versorgungsspannung an die Schaltendstufe angelegt werden und bei minimalen Eingangssignalen oder im Standby-Betrieb eine minimale Versorgungsspannung oder eine Versorgungsspannung von Null. Hierbei besteht die Anpassung der mittleren Amplitude des Ausgangssignals nicht oder nicht ausschließlich in der Anpassung der Abfolge und/oder des Vorzeichens der Pulse im Ausgangssignal sondern vornehmlich in der Anpassung der Amplitude der Pulse im Ausgangssignal. Bei kleinen Amplituden des Eingangssignals sind auch die Amplituden der Pulse im Ausgangssignal klein und umgekehrt. Da die Schaltverluste mit dem Quadrat der Versorgungsspannung bzw. mit dem Quadrat der Amplitude der Pulse im Ausgangssignal skalieren, können die Schaltverluste erheblich reduziert werden. Unnötig hohe Effizienzverluste bei geringen Amplituden des Eingangssignals können daher mithilfe des erfindungsgemäßen Verstärkers vermieden werden.

Für den Betrieb des erfindungsgemäßen Verstärkers muss die Versorgungsspannung jedoch nicht notwendigerweise an die Amplitude des Eingangssignals angepasst sein. Vielmehr ist es möglich den erfindungsgemäßen Verstärker mit einem breiten Spektrum von Versorgungsspannungen zu betreiben, ohne dass dazu eine zusätzliche Anpassung vorgenommen werden müsste, da aufgrund der Kompensationsmittel der stabile Betrieb des Verstärkers sichergestellt ist. Auf die Weise ist der Verstärker der Erfindung universell einsetzbar.

Eine vorteilhafte Weiterbildung des Verstärkers umfasst Mittel zum Variieren der Versorgungsspannung in Abhängigkeit von dem Eingangssignal. Das Variieren erfolgt dabei derart, dass bei kleinen Amplituden des Eingangssignals die Versorgungsspannung verringert wird und bei vergleichsweise großen Amplituden des Eingangssignals die Versorgungsspannung entsprechend erhöht wird.

Die Kompensationsmittel sind geeignet, das Signal in dem Signalpfadabschnitt der Schleife in Abhängigkeit der Versorgungsspannung in einer Weise zu verstärken bzw. zu verringern, die einer Änderung der Schleifenverstärkung aufgrund der Variation der Versorgungsspannung entgegenwirkt. Da Signalverstärkungen, die auf dem Signalpfadabschnitt in der Schleife vorgenommen werden, sowohl die Schleifenverstärkung als auch die Vorwärtsverstärkung in gleichem Maße beeinflussen, wird die Gesamtverstärkung durch diese Änderung nicht oder nur unwesentlich verändert.

Grundsätzlich bestehen unterschiedliche Möglichkeiten, die Verstärkung im Signalpfad zum Zweck der genannten Kompensation technisch zu realisieren. In einer ersten Alternative umfasst der Verstärker eine zusätzliche Modulator-Gegenkopplungsverbindung, um das Schaltsignal an einen Eingang der Modulationsmittel zurückzuführen und um das zurückgeführte Signal mit dem Signal am Eingang der Modulationsmittel zu kombinieren. In diesem Fall kann mithilfe der Kompensationsmittel das Signal auf der Modulator-Gegenkopplungsverbindung in Abhängigkeit von der Versorgungsspannung derart verstärkt bzw. verringert werden, dass der Änderung der Schleifenverstärkung aufgrund der Variation der Versorgungsspannung entgegengewirkt wird.

Die Verstärkung bzw. die Verringerung des Signals auf der Modulator-Gegenkopplungsverbindung besteht dabei vorzugsweise in einer Multiplikation mit der Versorgungsspannung oder mit einem Signal, das aus dieser abgeleitet ist. Eine Signalmultiplikation in der Modulator-Gegenkopplungsverbindung entspricht dabei funktional einer Signaldivision in Vorwärtsrichtung des Signalpfades. Die Vorwärtsrichtung ist diejenige Richtung, in der das Signal vom Verstärkereingang zum Verstärkerausgang verläuft, ohne auf einer Gegenkopplungsverbindung zurückgeführt zu werden. Die Signalmultiplikation hat gegenüber der Signaldivision den Vorteil, dass sie technisch einfacher zu realisieren ist.

Vorzugsweise umfassen die Kompensationsmittel einen Multiplexer für die Signalmultiplikation auf der Modulator-Gegenkopplungsverbindung. Der Multiplexer besitzt einen ersten Eingang für das Schaltsignal und einen zweiten Eingang für die Versorgungsspannung oder für ein Signal, das aus dieser abgeleitet ist. Der Multiplexer wird durch das zurückgeführte Schaltsignal gesteuert und erzeugt in Antwort auf das Schaltsignal ein Ausgangssignal. Beispielsweise kann das Schaltsignal ein binäres Signal sein, welches einen ersten Wert und einen zweiten Wert umfasst, wobei das Ausgangssignal für den ersten Wert beispielsweise dem Wert der Versorgungsspannung oder einem Wert entspricht, der aus der Versorgungsspannung abgeleitet ist. Für den zweiten Wert des Schaltsignals entspricht das Ausgangssignal beispielsweise dem entsprechenden invertierten Wert.

Ebenso kann das Schaltsignal auch ein ternäres Signal sein. Das Ausgangssignal des Multiplexers umfasst dann entsprechend drei Werte. Beispielsweise umfasst das Ausgangssignal des Multiplexers den Wert der Versorgungsspannung oder einen Wert, der aus der Versorgungsspannung abgeleitet ist, den entsprechend invertierten Wert und den Wert Null.

Die Modulationsmittel des Verstärkers umfassen vorzugsweise einen Sigma-Delta-Modulator zweiter Ordnung. Je höher die Ordnung des Sigma-Delta-Modulators ist, desto besser kann das in dem Modulator erzeugte Rauschen unterdrückt werden. Andererseits ist der Sigma-Delta-Modulator mit ansteigender Ordnung auch schwieriger zu stabilisieren. Die Phasenverschiebung des zurückgeführten Signals ist bei einem Sigma-Delta-Modulator höherer Ordnung gegenüber einem Sigma-Delta-Modulator erster Ordnung um einen Faktor erhöht, welcher der Ordnung des Sigma-Delta-Modulators entspricht. Es hat sich gezeigt, dass ein Sigma-Delta-Modulator zweiter Ordnung einen guten Kompromiss zwischen Phasenverschiebung und Rauschunterdrückung darstellt.

Das Schleifenfilter des Sigma-Delta-Modulators kann beispielsweise Integratoren und/oder Resonatoren umfassen und besitzt eine hohe Verstärkung für die zu verstärkenden Frequenzen im Audiobereich zwischen 0 - 20 kHz und eine Verstärkung von Eins oder kleiner für Frequenzen außerhalb dieses Bereiches. Die Zustandsvariablen dieses Schleifenfilters, wie beispielsweise die Ausgangssignale der Integratoren, weisen ein Sättigungsverhalten auf, das von dem Wert des auf der Modulator-Gegenkopplung zurückgeführten Signals abhängt. Damit der Sigma-Delta-Modulator in allen Betriebszuständen stabil bleibt, müssen die Zustandsvariablen des Schleifenfilters ein definiertes Sättigungsverhalten aufweisen. Dies wird vorzugsweise dadurch erreicht, dass die Begrenzungswerte oder Sättigungswerte der Zustandsvariablen mithilfe der Kompensationsmittel in Antwort auf die Variation der Versorgungsspannung entsprechend angepasst werden. Die Anzahl der Zustandsvariablen des Schleifenfilters entspricht der Ordnung des Schleifenfilters, die mit der Anzahl der Integratoren des Schleifenfilters übereinstimmt.

Vorzugsweise handelt es sich bei dem Sigma-Delta-Modulator um einen digitalen Sigma-Delta-Modulator, der auf einem hardwareprogrammierbaren Baustein, insbesondere auf einem FPGA (Field Programmable Gate Array) ausgeführt ist. Die beschriebene Erfindung bietet besonders in einer Realisierung auf einem FPGA Vorteile. Allerdings kann die Erfindung auch mithilfe eines integrierten Schaltkreises, insbesondere eines ASIC (Application Specific Integrated Circuit) realisiert werden.

Weiterhin ist dem Sigma-Delta-Modulator des erfindungsgemäßen Verstärkers in dem Signalpfad vorzugsweise ein digitales Schleifenfilter vorgeschaltet, das geeignet ist, das Eingangssignal zu empfangen, nachdem dieses mit dem Signal kombiniert wurde, welches über die Gegenkopplungsverbindung zurückgeführt wurde. Vorzugsweise ist das digitale Schleifenfilter - ebenso wie der Sigma-Delta-Modulator - auf dem hardwareprogrammierbaren Baustein, insbesondere auf dem FPGA, ausgeführt. Das digitale Schleifenfilter führt zu einer hohen Schleifenverstärkung für die zu verstärkenden Frequenzen, so dass Störungen mithilfe der Gegenkopplung wirksam unterdrückt werden können.

Vorzugsweise umfasst die Gegenkopplungsverbindung des Verstärkers weiterhin ein analoges Schleifenfilter und einen ersten Analog-Digital-Wandler, insbesondere einen Analog-Digital-Wandler zweiter Ordnung, dessen Eingang mit dem Ausgang des analogen Schleifenfilters verbunden ist. Mithilfe des ersten Analog-Digital-Wandlers wird das Ausgangssignal des analogen Schleifenfilters digitalisiert und an den FPGA weitergeleitet.

Ferner wird das Ausgangssignal des ersten Analog-Digital-Wandlers vorzugsweise über eine Digital-Analog-Gegenkopplungsverbindung zurückgeführt, um mit dem zurückgeführten Ausgangssignal der Schaltendstufe kombiniert zu werden. In der Digital-Analog-Gegenkopplungsverbindung ist ein Digital-Analog-Wandler angeordnet, der geeignet ist, das zurückgeführte Ausgangssignal des ersten Analog-Digital-Wandlers in ein analoges Signal umzuwandeln, bevor dieses mit dem über die Gegenkopplungsverbindung zurückgeführten analogen Ausgangssignal der Schaltendstufe kombiniert wird.

Vorzugsweise werden für den ersten Analog-Digital-Wandler und für den Digital-Analog-Wandler 1-Bit Wandler verwendet. Aufgrund der Verwendung des analogen Schleifenfilters, das im Audiobereich typischerweise eine hohe Schleifenverstärkung besitzt, kann für den ersten Analog-Digital-Wandler ein einfacher kostengünstiger 1-Bit Analog-Digital-Wandler verwendet werden

Alternativ können - z.B. bei höheren Qualitätsansprüchen - für den ersten Analog-Digital-Wandler und für den Digital-Analog-Wandler anstatt von 1-Bit Wandlern auch Wandler mit mehr als 1-Bit Wortbreite eingesetzt werden. In diesem Fall wird dem ersten Analog-Digital-Wandler vorzugsweise ein digitales Filter nachgeschaltet, dessen Ausgangssignal dann über die Digital-Analog-Gegenkopplungsverbindung zurückgeführt wird. Mithilfe des digitalen Filters können hochfrequente Signalanteile vermindert werden. Zusammen bilden das analoge Schleifenfilter, der erste Analog-Digital-Wandler, das digitale Filter, der Digital-Analog-Wandler und die Digital-Analog-Gegenkopplungsverbindung einen kostengünstigen Analog-Digital-Wandler für das zurückgeführte Ausgangssignal der Schaltendstufe.

Um das Ausgangssignal der Schaltendstufe zu glätten, umfasst der Verstärker vorzugsweise ein Filter, das im Signalpfad in Vorwärtsrichtung hinter der Schaltendstufe angeordnet ist. Die Gegenkopplungsverbindung ist dabei ausgangsseitig nach dem Ausgang der Schaltendstufe und vor dem Eingang des Filters mit dem Signalpfad verbunden. Alternativ ist die Gegenkopplungsverbindung nach dem Ausgang des Filters mit dem Signalpfad verbunden. Die Gegenkopplungsverbindung ist somit geeignet, das Ausgangssignal der Schaltendstufe vor oder nach dem Filter zurückzuführen.

Vorzugsweise enthält der Verstärker einen zweiten Analog-Digital-Wandler, der geeignet ist, die Versorgungsspannung in ein digitales Signal umzuwandeln und dieses an die Kompensationsmittel weiterzuleiten. Somit kann die zumindest teilweise Kompensation von Änderungen in der Schleifenverstärkung, die sich aufgrund einer Variation der Versorgungsspannung ergeben, digital auf dem FPGA erfolgen. Dieses Signal ist ein Beispiel für ein eingangs erwähntes Signal, das aus der Versorgungsspannung "abgeleitet" ist.

Der Verstärker enthält vorzugsweise einen Anschluss für die Versorgungsspannung, die über ein Netzteil zur Verfügung gestellt wird, welches in einer Ausführungsform der Erfindung nicht Teil des Verstärkers selbst ist. Die Versorgungsspannung wird verstärkerextern bereitgestellt und an den dafür vorgesehenen Anschluss des Verstärkers angeschlossen.

Die Schaltendstufe des Verstärkers wird vorzugsweise durch eine H-Brücke gebildet. Dabei bestehen die Schaltmittel des Verstärkers vorzugsweise aus Power-MOSFET-Transistoren, die durch das Schaltsignal geschaltet werden.

Für die digitale Signalverarbeitung und die digitale Signalerzeugung enthält der Verstärker vorzugsweise eine Taktquelle. Diese stellt für den Betrieb des ersten Analog-Digital-Wandlers eine Abtastfrequenz von $\geq$ 100 kHz, vorzugsweise von $\geq$ 1 MHz, besonders vorzugsweise von $\geq$ 10 MHz bereit. Die verschiedenen notwendigen Taktfrequenzen können direkt durch die Taktquelle bereitgestellt oder im FPGA aus der Taktquelle abgeleitet werden.

In einer zweiten Alternative des erfindungsgemäßen Verstärkers sind die Kompensationsmittel geeignet, das Signal auf dem Signalpfad in der Schleife mit der Versorgungsspannung der Schaltendstufe oder mit einem aus diesem abgeleiteten Signal zu dividieren. Die Division auf dem Signalpfad in der Schleife verändert in gleichem Maße die Vorwärtsverstärkung und die Schleifenverstärkung, so dass die Gesamtverstärkung im Wesentlichen unverändert bleibt.

Weiterhin beinhaltet die Erfindung ein Verfahren nach Anspruch 12 zur Verstärkung eines Eingangssignals und ein Verfahren nach Anspruch 14 zur Verstärkung eines Eingangssignals.

Vorzugsweise werden die Verfahren jeweils durch einen Verstärker nach einer der oben genannten Ausführungsformen ausgeführt.

## KURZBESCHREIBUNG DER FIGUREN

Weitere Vorteile und Merkmale der Erfindung ergeben sich aus der folgenden Beschreibung, in der die Erfindung anhand eines bevorzugten Ausführungsbeispiels unter Bezugnahme auf die beigefügten Zeichnungen näher erläutert wird. Darin zeigen:

Figur 1 ein Blockschaltbild des erfindungsgemäßen Verstärkers mit digitalem Schleifenfilter und digitalem Sigma-Delta-Modulator,

Figur 2 ein Blockschaltbild des internen Sigma-Delta-Modulators, und

Figur 3     ein Blockschaltbild eines digitalen Integrators mit angepasster Sättigung.

BESCHREIBUNG DER BEVORZUGTEN AUSFÜHRUNGSFORM

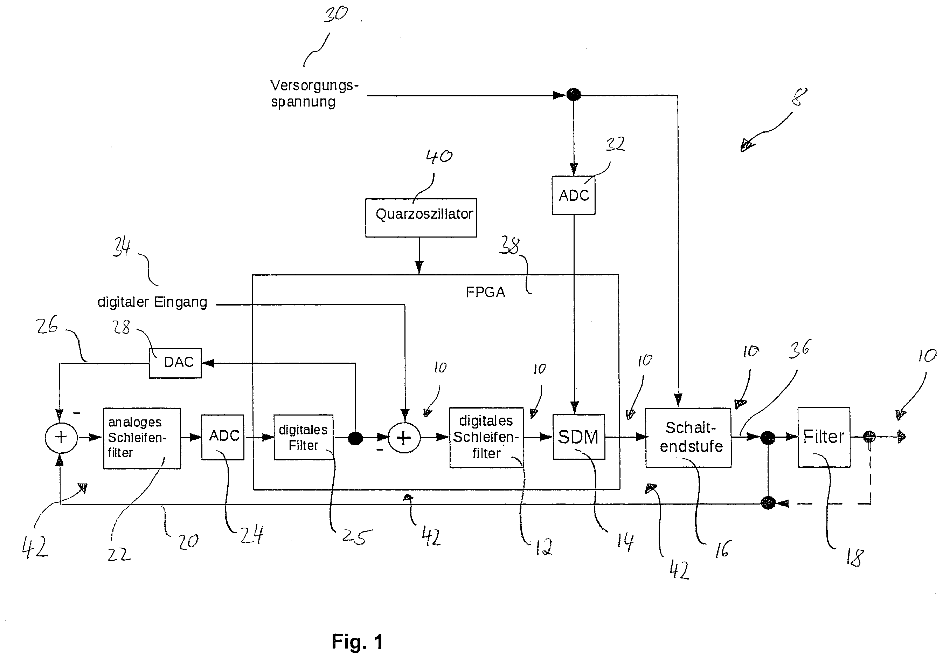

Figur 1 zeigt ein Ausführungsbeispiel des erfindungsgemäßen Verstärkers 8. Dieser umfasst einen Signalpfad 10, in dem nacheinander in Vorwärtsrichtung ein digitales Schleifenfilter 12, ein digitaler Sigma-Delta-Modulator 14, eine Schaltendstufe 16 und ein Filter 18 angeordnet sind. Die Schaltendstufe 16 wird dabei durch eine H-Brücke gebildet. Weiterhin ist eine Gegenkopplungsverbindung 20 dargestellt, die an ihrem Eingang mit dem Signalpfad 10 zwischen der Schaltendstufe 16 und dem Filter 18 oder alternativ mit dem Signalpfad 10 nach dem Filter 18 verbunden ist. In der Gegenkopplungsverbindung 20 sind weiterhin ein analoges Schleifenfilter 22, ein erster Analog-Digital-Wandler 24 und ein digitales Filter 25 nacheinander in Signalrichtung angeordnet. Eine Digital-Analog-Gegenkopplungsverbindung 26 ist an ihrem Eingang mit dem Ausgang des digitalen Filters 25 und an ihrem Ausgang mit dem Eingang des analogen Schleifenfilters 22 verbunden. Innerhalb der Digital-Analog-Gegenkopplungsverbindung 26 ist weiterhin ein Digital-Analog-Wandler 28 enthalten. Der Verstärker 8 wird mit einer Versorgungsspannung 30 betrieben, die variabel sein kann, und die mit der Schaltendstufe 16 und - über einen zweiten Analog-Digital-Wandler 32 - mit dem digitalen Sigma-Delta-Modulator 14 verbunden ist. Ein digitaler Eingang 34 bildet den Eingang des Signalpfades 10, auf dem nach der Schaltendstufe 16 das Ausgangssignal 36 bereitgestellt wird. Das digitale Schleifenfilter 12, der Sigma-Delta-Modulator 14 und das digitale Filter 25 sind auf einem hardwareprogrammierbaren Baustein 38 ausgeführt, der aus einem FPGA besteht und mit einer Taktquelle 40 verbunden ist. Zusammen mit dem Signalpfad 10 bildet die Gegenkopplungsverbindung 20 eine Schleife 42.

Über die Gegenkopplungsverbindung 20 wird das analoge Ausgangssignal 36 der Schaltendstufe 16 oder alternativ das Ausgangssignal hinter dem Filter 18 zurückgeführt, um mit dem Eingangssignal kombiniert zu werden. Die Kombination erfolgt typischerweise derart, dass das um 180° zu dem Eingangssignal phasenverschobene, zurückgeführte Signal mit dem Eingangssignal addiert wird. Dies entspricht einer Signalsubtraktion. Mithilfe der Gegenkopplung werden Störeffekte, die auf dem Signalpfad 10 innerhalb der Schleife 42 entstehen, beseitigt oder zumindest unterdrückt. Ein Beispiel für einen solchen Störeffekt ist ein nichtlineares Verhalten in der Schaltendstufe 16, das zu Klangverzerrungen führt.

Bevor das zurückgeführte Signal mit dem Eingangssignal kombiniert wird, wird es mithilfe des analogen Schleifenfilters 22 verstärkt und anschließend mithilfe des ersten Analog-Digital-Wandlers 24 digitalisiert. Weiterhin werden mithilfe des digitalen Filters 25 hochfrequente Signalanteile in dem digitalisierten Signal nach dem ersten Analog-Digital-Wandler 24 vermindert. Der erste Analog-Digital-Wandler 24 ist dabei vorzugsweise ein Sigma-Delta Analog-Digital-Wandler zweiter Ordnung, der vorzugsweise mit einer Taktfrequenz > 10 MHz betrieben wird.

Das mit dem zurückgeführten Ausgangssignal kombinierte Eingangssignal wird durch das digitale Schleifenfilter 12 für den erforderlichen Frequenzbereich verstärkt und für höhere Frequenzen oberhalb dieses Frequenzbereiches unverstärkt oder abgeschwächt an den digitalen Sigma-Delta-Modulator 14 weitergegeben.

Mithilfe der Digital-Analog-Gegenkopplungsverbindung 26 wird das Ausgangssignal des digitalen Filters 25 zurückgeführt, um mit dem zurückgeführten Ausgangssignal 36 der Schaltendstufe 16 kombiniert zu werden. Bevor das digitale Ausgangssignal des digitalen Filters 25 kombiniert wird, wird dieses mithilfe des Digital-Analog-Wandlers 28 in ein analoges Signal umgewandelt. Ebenso wie der erste Analog-Digital-Wandler 24 wird auch der Digital-Analog-Wandler 28 mit einer Taktfrequenz von vorzugsweise > 10 MHz betrieben. Aufgrund der Verwendung einer Taktfrequenz von > 10 MHz entstehen bei der Umwandlung zwischen digitalen und analogen Signalen keine oder nur geringe Fehler, so dass keine oder nur eine sehr einfache Aliasingfilterung notwendig ist, mit der üblicherweise Effekte vermindert werden, die durch eine zu geringe Taktfrequenz bei der Umwandlung zwischen digitalen und analogen Signalen entstehen (sog. Alias-Effekte).

In Antwort auf das Ausgangssignal des digitalen Schleifenfilters 12 erzeugt der digitale Sigma-Delta-Modulator 14 ein Schaltsignal, bei welchem es sich um ein digitales Signal handelt, das beispielsweise die Werte "0" und "1" annehmen kann.

Das Schaltsignal wird von der Schaltendstufe 16 empfangen, die in Antwort auf das Schaltsignal das Ausgangssignal 36 erzeugt. Die Schaltendstufe 16 enthält Schaltmittel, die in Abhängigkeit des Schaltsignals geschaltet werden und dabei einen von zwei diskreten Schaltzuständen annehmen. Die Schaltmittel der Schaltendstufe 16 können beispielsweise durch Power-MOSFET-Transistoren gebildet werden. Beim Ansteuern der Schaltmittel entspricht beispielsweise der Signalwert "0" des Schaltsignals einem Schaltzustand "geschlossen" und der Signalwert "1" des Schaltsignals einem Schaltzustand "offen" oder umgekehrt, je nachdem welches spezielle Schaltmittel betrachtet wird. Somit werden in Antwort auf das Schaltsignal die Schaltmittel der Schaltendstufe 16 geschaltet und in Antwort auf die Schaltvorgänge einzelne Pulse im Ausgangssignal 36 erzeugt. Die Amplitude und das Vorzeichen der Pulse im Ausgangssignal 36 hängen dabei vom Wert der anliegenden Versorgungsspannung 30 und vom Wert des Schaltsignals ab. Beispielsweise wird für den Wert "1" des Schaltsignals ein Puls oder ein Pulsbeitrag im Ausgangssignal 36 erzeugt, welcher der Versorgungsspannung 30 entspricht. Für den Wert "0" des Schaltsignals wird dann beispielsweise ein entsprechend invertierter Puls oder Pulsbeitrag im Ausgangssignal 36 erzeugt. Somit weist auch das Ausgangssignal 36 - entsprechend der zwei Signalwerte des Schaltsignals - zwei diskrete Werte auf, deren Betrag von der an der Schaltendstufe 16 anliegenden Versorgungsspannung 30 abhängt.

Die Verstärkung des Eingangssignals durch den Verstärker 8 zu dem Ausgangssignal 36 erfolgt derart, dass die mittlere Amplitude des Ausgangssignals 36 im Wesentlichen der um einen bestimmten Faktor verstärkten mittleren Amplitude des Eingangssignals entspricht. Wenn das Ausgangssignal 36 auf einem Zeitabschnitt einer bestimmten Länge nur positive Pulse bzw. nur negative Pulse enthält, dann nimmt die mittlere Amplitude des Ausgangssignals 36 auf diesem Zeitabschnitt für die anliegende Versorgungsspannung 30 ihren maximalen bzw. ihren minimalen Wert an. Hierbei spricht man von einer 100 % positiven bzw. von einer 100 % negativen Auskopplung. Wenn das Ausgangssignal 36 auf einem Zeitabschnitt einer bestimmten Länge annähernd gleich viele positive und negative Pulse enthält, dann nimmt die mittlere Amplitude des Ausgangssignals 36 auf diesem Zeitabschnitt annähernd den Wert Null an. In diesem Fall liegt eine Auskopplung von 0 % vor. Die mittlere Amplitude des Ausgangssignals 36 wird somit von dem Grad der Auskopplung und der anliegenden Versorgungsspannung 30 bestimmt. Der Grad der Auskopplung ist dabei durch das Schaltsignal bestimmt, welches mithilfe des digitalen Sigma-Delta-Modulators 14 in Antwort auf das Eingangssignal erzeugt wird.

Man erkennt, dass bei schwachen Eingangssignalen eine vergleichsweise geringe Auskopplung vorliegen wird, um die entsprechende vergleichsweise geringe mittlere Amplitude des Ausgangssignals 36 zu erzeugen. Dies bedeutet aber, dass für diesen Fall die Versorgungsspannung 30 der Schaltendstufe 16 höher ist als eigentlich nötig. Gleichzeitig stellen hohe Versorgungsspannungen 36 bei schwachen Eingangssignalen ein Problem bezüglich der Energieeffizienz dar, weil die Schaltverluste der Schaltendstufe 16 quadratisch mit der Versorgungsspannung 30 skalieren.

Der Erfinder hat erkannt, dass sich die Energieeffizienz steigern lässt, wenn die Versorgungsspannung 30 - bei an sich unveränderter Gesamtverstärkung - an das Eingangssignal angepasst werden kann, so dass bei schwächeren Eingangssignalen unnötig hohe Versorgungsspannungen 30 vermieden werden können.

Eine solche Funktionsweise wird durch den gezeigten Aufbau an sich dadurch begünstigt, dass die Gesamtverstärkung aufgrund der Gegenkopplungsverbindung 20 im Wesentlichen unabhängig von der Versorgungsspannung 30 ist. Allerdings führt die Veränderung der Versorgungsspannung 30, wie unten näher erläutert wird, zu einer Änderung der Schleifenverstärkung, die ihrerseits eine Instabilität der Gegenkopplung zur Folge hat. Die Erfindung schlägt daher vor, Änderungen in der Schleifenverstärkung, die sich aus der im Rahmen der Erfindung möglichen Variation der Versorgungsspannung 30 ergibt, auf geeignete Weise zu kompensieren und dadurch die Stabilität der Gegenkopplung zu gewährleisten. Dies wird im Folgenden im Detail erläutert.

Die Gesamtverstärkung $A_G$, mit der das Eingangssignal zu dem Ausgangssignal verstärkt wird, ergibt sich aus der Vorwärtsverstärkung $A_V$ und der Schleifenverstärkung $A_S$ aus folgender Formel:

$$A_G = \frac{A_V}{1 + A_S}$$

Dabei ist die Schleifenverstärkung $A_S$ diejenige Verstärkung, mit der ein Signal bei einmaligem Durchlauf durch die Schleife 42 verstärkt wird, und die Vorwärtsverstärkung $A_V$ diejenige Verstärkung, mit der das Eingangssignal ohne Gegenkopplung zu dem Ausgangssignal 36 verstärkt würde. Der erfindungsgemäße Verstärker besitzt für den Audiobereich von 0 bis 10 kHz vorzugsweise eine Schleifenverstärkung von $\geq$ 30 dB, vorzugsweise von $\geq$ 40 dB und besonders vorzugsweise von $\geq$ 50 dB.

Aufgrund der Gegenkopplung wird die Gesamtverstärkung $A_G$, die ohne Gegenkopplung der Vorwärtsverstärkung $A_V$ entspräche, um den Faktor $(1+A_S)^{-1}$ reduziert, wodurch das Verstärkerverhalten auf Kosten der Gesamtverstärkung $A_G$ linearisiert und stabilisiert wird.

Da sich die Schaltendstufe 16 auf dem Signalpfad 10 innerhalb der Schleife 42 befindet, ist sowohl die Schleifenverstärkung $A_S$ als auch die Vorwärtsverstärkung $A_V$ proportional zur anliegenden Versorgungsspannung. D.h.

$$A_S = K_U \bullet A_{SU}$$

und

$$A_V = K_U \bullet A_{VU},$$

wobei $K_U$ der von der Versorgungsspannung 30 abhängige Proportionalitätsfaktor ist, und wobei $A_{SU}$ bzw. $A_{VU}$ der Anteil der Schleifen- bzw. Vorwärtsverstärkung ist, der nicht mit der Versorgungsspannung 30 variiert.

Da sowohl die Vorwärtsverstärkung $A_V$ als auch die Schleifenverstärkung $A_S$ für das zu verstärkende Eingangssignal wesentlich größer sind als Eins ($A_V$, $A_S$) >> 1, entspricht die Gesamtverstärkung $A_G$ näherungsweise dem Quotienten g aus Vorwärtsverstärkung $A_V$ und Schleifenverstärkung $A_S$, der unabhängig von der anliegenden Versorgungsspannung 30 ist:

$$A_G = \frac{A_V}{1 + A_S} = \frac{K_U \cdot A_{VU}}{1 + K_U \cdot A_{SU}} \approx g$$

Daher bleibt die Gesamtverstärkung $A_G$, mit der das Eingangssignal zum Ausgangssignal 36 verstärkt wird, auch bei einer Variation der Versorgungsspannung 30 aufgrund der Gegenkopplungsverbindung 20 im Wesentlichen unverändert. Bei einer verringerten Versorgungsspannung 30 sind auch die Schleifenverstärkung $A_S$ und die Vorwärtsverstärkung $A_V$ verringert, so dass die Gesamtverstärkung $A_G$ im Wesentlichen erhalten bleibt. Der Grad der Auskopplung wird dabei automatisch entsprechend erhöht.

Für den energieeffizienten Betrieb kann somit bei schwachen Eingangssignalen die Versorgungsspannung 30 entsprechend angepasst werden, so dass der Grad der Auskopplung erhalten bleibt.

Bei bekannten geschalteten Verstärkern mit Gegenkopplung würde bei einer Variation der Versorgungsspannung auch die Schleifenverstärkung $A_S$ verändert. Dies führt jedoch bei bestimmten Signalfrequenzen zu einer Verschiebung der Phase des zurückgeführten Ausgangssignals und dadurch zu einer Instabilität des Verstärkers.

Um dieser Instabilität entgegenzuwirken, umfasst der erfindungsgemäße Verstärker 8 Kompensationsmittel, welche die an der Schaltendstufe 16 anliegende Versorgungsspannung 30 oder ein aus dieser abgeleitetes Signal empfangen und geeignet sind, Änderungen in der Schleifenverstärkung, die sich aufgrund einer Variation der Versorgungsspannung 30 ergeben, zumindest teilweise zu kompensieren.

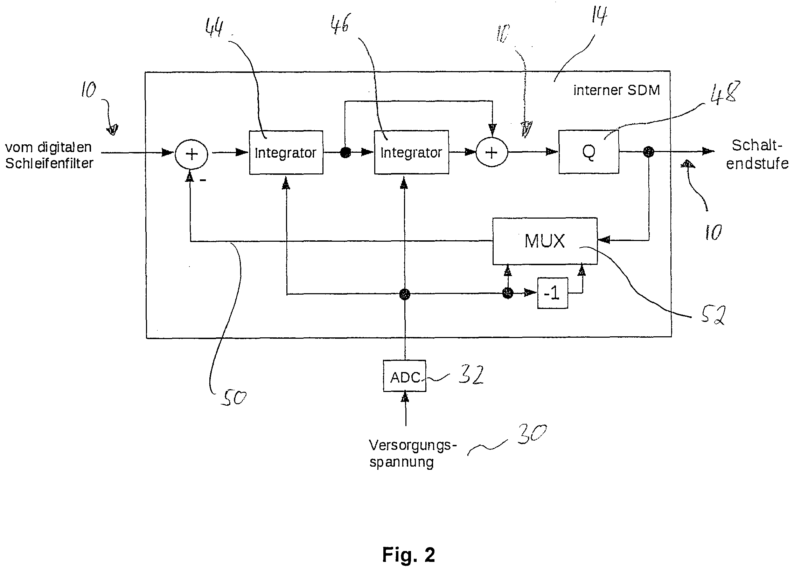

In einer bevorzugten Ausführungsform des erfindungsgemäßen Verstärkers 8 erfolgt die zumindest teilweise Kompensation der Änderung in der Schleifenverstärkung $A_S$ in dem Sigma-Delta-Modulator 14. Dies ist in Figur 2 dargestellt.

Figur 2 zeigt den Sigma-Delta-Modulator 14, durch den der Signalpfad 10 verläuft. Auf dem Signalpfad 10 innerhalb des Sigma-Delta-Modulators 14 sind nacheinander ein erster Integrator 44, ein zweiter Integrator 46 und ein Quantisierer 48 angeordnet. Ferner enthält der Sigma-Delta-Modulator 14 eine Modulator-Gegenkopplungsverbindung 50, die in der vorliegenden Beschreibung als Teil des Signalpfades 10 betrachtet wird und auf der ein Multiplexer 52 angeordnet ist. Weiterhin zeigt Figur 2 den zweiten Analog-Digital-Wandler 32, der die Versorgungsspannung 30 empfängt und der mit dem ersten und mit dem zweiten Integrator 44 und 46 und zusätzlich mit dem Multiplexer 52 verbunden ist.

Mithilfe der Modulator-Gegenkopplungsverbindung 50 wird das Schaltsignal vom Ausgang des Sigma-Delta-Modulators 14 zurückgeführt und anschließend mit einem aus der Versorgungsspannung 30 abgeleiteten digitalen Signal multipliziert, welches mithilfe des zweiten Analog-Digital-Wandler 32 erzeugt wird. Die Signalmultiplikation mithilfe des Multiplexers 52 erfolgt dabei derart, dass der Multiplexer 52 mithilfe des Schaltsignals, welches beispielsweise die Werte "0" oder "1" umfasst, geschaltet wird, und somit in Antwort auf das Schaltsignal den Wert oder den invertierten Wert des digitalen Signals bereitstellt, welches aus der Versorgungsspannung 30 abgeleitet ist. Das von dem Multiplexer 52 derart bereitgestellte Signal wird über die Modulator-Gegenkopplungsverbindung 50 zurückgeführt und mit dem Ausgangssignal des digitalen Schleifenfilters 12 kombiniert. Die Signalmultiplikation mit dem aus der Versorgungsspannung 30 abgeleiteten Signal in der Modulator-Gegenkopplungsverbindung 50 entspricht dabei effektiv einer Signaldivision in Vorwärtsrichtung des Signalpfades 10. Die Signalrichtung auf der Modulator-Gegenkopplungsverbindung 50 entspricht der Rückwärtsrichtung des Signalpfades 10. Durch diese Division wird die zur Versorgungsspannung 30 proportionale Änderung der Schleifenverstärkung, die sich an der Schaltendstufe 16 bei einer Variation der Versorgungsspannung 30 ergibt, zumindest teilweise kompensiert. Eine aufwendige Signaldivision wird somit durch eine einfacher durchzuführende Signalmultiplikation ersetzt, die zudem aufgrund eines binären oder ternären Schaltsignals lediglich aus einem Multiplexen mithilfe des Multiplexers 52 besteht.

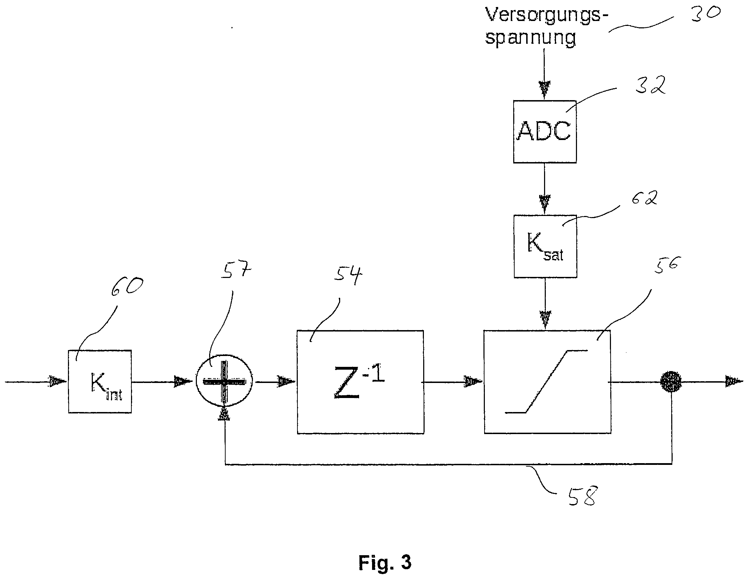

Um sicherzustellen, dass der Sigma-Delta-Modulator 14 stabil bleibt, werden weiterhin die Zustandsvariablen des ersten und zweiten Integrators 44 und 46 angepasst. Dies wird im Folgenden anhand von Figur 3 erläutert:

Figur 3 zeigt das Blockschaltbild eines digitalen Integrators, wie er für den ersten und zweiten Integrator 44 und 46 verwendet werden kann, die auf dem hardwareprogrammierbaren Baustein 38, insbesondere auf dem FPGA ausgeführt sind. In Figur 3 sind die . Versorgungsspannung 30, die mit dem zweiten Analog-Digital-Wandler 32, verbunden ist, und der digitale Integrator dargestellt, der ein Verzögerungsglied 54, eine Integratorsättigung 56, einen Addierer 57 und eine Integratorrückführung 58 umfasst. Am Eingang des digitalen Integrators liegt ein Integrationskoeffizient 60. Die Integratorsättigung 56 wird durch einen Sättigungswert 62 bestimmt.

Der Integrator erhöht seinen Ausgangswert, der über die Integratorrückführung 58 an den Addierer 57 zurückgeführt wird, mit jedem Taktzyklus um den mit dem Integrationskoeffizienten 60 multiplizierten Integratoreingangswert. Die Integratorsättigung 56 stellt sicher, dass der Ausgangswert des Integrators den Sättigungswert 62 nicht übersteigt. Für die Stabilität des Sigma-Delta-Modulators 14 ist es notwendig, dass die Zustandsvariablen des ersten und zweiten Integrators 44 und 46, also deren Ausgangswerte, ein definiertes, von der Versorgungsspannung 30 unabhängiges Sättigungsverhalten aufweisen. Da das auf der Modulator-Gegenkopplungsverbindung 50 zurückgeführte Signal in Abhängigkeit der Versorgungsspannung 30 verändert wird, ändert sich auch der Integratoreingangswert in Abhängigkeit der Versorgungsspannung 30 und damit der Eintritt der Sättigung in Abhängigkeit der Versorgungsspannung 30. Damit das Sättigungsverhalten des ersten und zweiten Integrators 44 und 46 auch bei einer Variation der Versorgungsspannung 30 definiert bleibt, werden die Sättigungswerte 62 des ersten und zweiten Integrators 44 und 46 entsprechend der Variation der Versorgungsspannung 30 angepasst. Somit wird die Stabilität des Sigma-Delta-Modulators 14 auch bei einer Variation der Versorgungsspannung 30 sichergestellt.

Der in Figur 1, insbesondere in Figur 2 und 3, beschriebene Verstärker stellt eine besonders vorteilhafte Ausführungsform der Erfindung dar, da die Signalanpassung über eine Signalmultiplikation mit dem Schaltsignal durchgeführt wird, das eine Wortbreite von nur einem Bit aufweist, so dass der Hardwareaufwand sehr gering ist und mithilfe eines einfachen Multiplexers 52 realisiert werden kann. Weiterhin muss die Auflösung des zweiten Analog-Digital-Wandlers 32, der ein digitales Signal aus der Versorgungsspannung 30 bereitstellt, nicht besonders hoch sein, da Störungen in der Modulator-Gegenkopplung 50 an dieser Stelle durch die Gegenkopplungsverbindung 20 unterdrückt werden.

Anstelle eines FPGA kann der erfindungsgemäße Verstärker alternativ auch mithilfe eines ASIC ausgeführt werden, wobei die in der obigen Beschreibung dem FPGA zugewiesenen Schaltungsteile dann im ASIC digital realisiert würden.

Der erfindungsgemäße Verstärker ist jedoch nicht auf das oben beschriebene Ausführungsbeispiel beschränkt. Eine weitere Möglichkeit die Schleifenverstärkung $A_S$ anzupassen besteht in einer Signalmultiplikation in der Gegenkopplungsverbindung 20. Dabei wird jedoch die Gesamtverstärkung $A_G$ verändert, so dass zusätzlich eine entsprechende Signalanpassung im Signalpfad 10 außerhalb der Schleife 42 notwendig ist, die sich nur auf die Vorwärtsverstärkung $A_V$, jedoch nicht auf die Schleifenverstärkung $A_S$ auswirkt. Somit kann mit zwei Anpassungen an verschiedenen Stellen des Verstärkers sowohl die Schleifenverstärkung $A_S$ als auch die Gesamtverstärkung $A_G$ bei einer Variation der an der Schaltendstufe 16 anliegenden Versorgungsspannung 30 zumindest annähernd konstant gehalten werden.

Eine andere Möglichkeit besteht in einer Signaldivision in Vorwärtsrichtung des Signalpfades 10 innerhalb der Schleife 42. Die Wortbreite des zu dividierenden Signals ist dabei jedoch vergleichsweise hoch, so dass der notwendige Hardwareaufwand im Vergleich zu dem bevorzugten Ausführungsbeispiel hoch ist..

Obgleich in den Zeichnungen und in der vorhergehenden Beschreibung ein bevorzugtes Ausführungsbeispiel aufgezeigt und detailliert beschrieben wurde, sollte dies als rein beispielhaft und die Erfindung nicht einschränkend angesehen werden. Es wird darauf hingewiesen dass nur das bevorzugte Ausführungsbeispiel detailliert dargestellt und beschrieben wurde und Änderungen und Modifizierungen, die derzeit und künftig im Schutzumfang der Erfindung liegen, geschützt werden sollen. Die gezeigten Merkmale können in beliebigen Kombinationen von Bedeutung sein.

BEZUGSZEICHENLISTE

| | |
|---|---|
| 8 | Verstärker |
| 10 | Signalpfad |
| 12 | Digitales Schleifenfilter |
| 14 | Digitaler Sigma-Delta-Modulator |
| 16 | Schaltendstufe |
| 18 | Filter |
| 20 | Gegenkopplungsverbindung |
| 22 | Analoges Schleifenfilter |
| 24 | Erster Analog-Digital-Wandler |
| 25 | Digitales Filter |
| 26 | Digital-Analog-Gegenkopplungsverbindung |
| 28 | Digital-Analog-Wandler |
| 30 | Variable Versorgungsspannung |
| 32 | Zweiter Analog-Digital-Wandler |
| 34 | Digitaler Eingang |
| 36 | Ausgangssignal |
| 38 | Hardwareprogrammierbarer Baustein |
| 40 | Taktquelle |
| 42 | Schleife |
| 44 | Erster Integrator |
| 46 | Zweiter Integrator |
| 48 | Quantisierer |
| 50 | Modulator-Gegenkopplungsverbindung |
| 52 | Multiplexer |
| 54 | Verzögerungsglied |
| 56 | Integratorsättigung |
| 57 | Addierer |
| 58 | Integratorrückführung |
| 60 | Integrationskoeffizient |
| 62 | Sättigungswert |

BEZUGSZEICHENLISTE

| | |
|---|---|
| 8 | Verstärker |
| 10 | Signalpfad |
| 12 | Digitales Schleifenfilter |
| 14 | Digitaler Sigma-Delta-Modulator |
| 16 | Schaltendstufe |
| 18 | Filter |
| 20 | Gegenkopplungsverbindung |
| 22 | Analoges Schleifenfilter |
| 24 | Erster Analog-Digital-Wandler |
| 25 | Digitales Filter |
| 26 | Digital-Analog-Gegenkopplungsverbindung |
| 28 | Digital-Analog-Wandler |
| 30 | Variable Versorgungsspannung |
| 32 | Zweiter Analog-Digital-Wandler |
| 34 | Digitaler Eingang |
| 36 | Ausgangssignal |
| 38 | Hardwareprogrammierbarer Baustein |
| 40 | Taktquelle |
| 42 | Schleife |

44     Erster Integrator
46     Zweiter Integrator
48     Quantisierer
50     Modulator-Gegenkopplungsverbindung
52     Multiplexer
54     Verzögerungsglied
56     Integratorsättigung
57     Addierer
58     Integratorrückführung
60     Integrationskoeffizient
62     Sättigungswert

**Patentansprüche**

1. Verstärker (8) zur Verstärkung eines Eingangssignals zu einem Ausgangssignal (36), der einen Signalpfad (10) und eine Gegenkopplungsverbindung (20) umfasst,
wobei der Signalpfad (10)

    - Modulationsmittel (14) umfasst, die geeignet sind, das Eingangssignal zu empfangen und in Antwort auf das empfangene Eingangssignal ein Schaltsignal zu erzeugen, und
    - eine Schaltendstufe (16) umfasst, die mit einer Versorgungsspannung (30) verbunden ist, wobei die Schaltendstufe (16) Schaltmittel umfasst, die entsprechend dem von den Modulationsmitteln (14) erzeugten Schaltsignal geschaltet werden, und die Schaltendstufe (16) ein Ausgangssignal (36) erzeugt, dessen Amplitude von der Versorgungsspannung (30) abhängt,

und wobei die Gegenkopplungsverbindung (20) geeignet ist, das Ausgangssignal (36) der Schaltendstufe (16) zurückzuführen, um mit dem Eingangssignal kombiniert zu werden,
wobei der Signalpfad (10) und die Gegenkopplungsverbindung (20) eine Schleife (42) mit einer Schleifenverstärkung bilden,
wobei der Verstärker Kompensationsmittel (52) umfasst, welche die Versorgungsspannung (30) der Schaltendstufe (16) oder ein aus dieser abgeleitetes Signal empfangen, und die geeignet sind, Änderungen in der Schleifenverstärkung, die sich aufgrund einer Variation der Versorgungsspannung (30) ergeben, zumindest teilweise zu kompensieren, **dadurch gekennzeichnet, dass**
die Kompensationsmittel (52) geeignet sind, durch ein Eingreifen in den Signalpfadabschnitt innerhalb der Schleife (42) eine Verstärkung bzw. eine Verringerung des Signals in dem Signalpfadabschnitt innerhalb der Schleife (42) in Abhängigkeit der Versorgungsspannung (30) in einer Weise vorzunehmen, die einer Änderung der Schleifenverstärkung aufgrund der Variation der Versorgungsspannung (30) entgegenwirkt,

der Verstärker zusätzlich eine Modulator-Gegenkopplungsverbindung (50) umfasst, die geeignet ist, das Schaltsignal an einen Eingang der Modulationsmittel (14) zurückzuführen, um mit dem Signal am Eingang der Modulationsmittel (14) kombiniert zu werden, und
bei dem Verstärker die Kompensationsmittel (52) geeignet sind, das Signal auf der Modulator-Gegenkopplungsverbindung (50) in Abhängigkeit der Versorgungsspannung (30) in einer Weise zu verstärken bzw. zu verringern, die einer Änderung der Schleifenverstärkung aufgrund der Variation der Versorgungsspannung (30) entgegenwirkt.

2. Verstärker (8) nach Anspruch 1, bei dem die Kompensationsmittel (52) geeignet sind, die Versorgungsspannung (30) der Schaltendstufe (16) oder ein aus dieser abgeleitetes Signal mit dem Signal auf der Modulator-Gegenkopplungsverbindung (50) zu multiplizieren, bei dem vorzugsweise die Kompensationsmittel (52) einen Multiplexer (52) umfassen und bei dem die Versorgungsspannung (30) der Schaltendstufe (16) oder ein aus dieser abgeleitetes Signal derart durch den Multiplexer (52) mit dem Schaltsignal multipliziert wird, dass ein Signal gebildet wird, das zumindest annähernd den Wert oder den invertierten Wert der Versorgungsspannung (30) oder zumindest annähernd den Wert oder den invertierten Wert eines Signals besitzt, das aus der Versorgungsspannung (30) abgeleitet ist.

3. Verstärker (8) nach Anspruch 2, bei dem die Modulationsmittel (14) einen Sigma-Delta-Modulator (14) umfassen, wobei der Sigma-Delta-Modulator (14) vorzugsweise ein Schleifenfilter (44, 46) mit zwei oder mehr Integratoren umfasst, bei dem vorzugsweise das Schleifenfilter (44, 46) Zustände annehmen kann, die durch mindestens eine Zustandsvariable beeinflusst werden, für die das Schleifenfilter (44, 46) einen Begrenzungswert (62) aufweist, wobei die Kompensationsmittel geeignet sind, den Begrenzungswert (62) in Antwort auf die Variation der Versorgungsspannung (30) entsprechend anzupassen.

4. Verstärker (8) nach Anspruch 3, bei dem der Sigma-Delta-Modulator (14) auf einem hardwareprogrammierbaren Baustein (38), insbesondere auf einem FPGA ausgeführt ist, wobei vorzugsweise der Verstärker (8) zusätzlich ein digitales Schleifenfilter (12) umfasst, das im Signalpfad (10) vor dem Sigma-Delta-Modulator (14) angeordnet ist und das geeignet ist, das Eingangssignal zu empfangen und zu verstärken, nachdem dieses mit dem durch die Gegenkopplungsverbindung (20) zurückgeführten Ausgangssignal (36) kombiniert wurde, wobei das digitale Schleifenfilter (12) auf dem hardwareprogrammierbaren Baustein (38), insbesondere auf dem FPGA ausgeführt ist.

5. Verstärker (8) nach Anspruch 4, der in der Gegenkopplungsverbindung weiterhin folgendes umfasst:

    - ein analoges Schleifenfilter (22), und
    - einen ersten Analog-Digital-Wandler (24), insbesondere einen Analog-Digital-Wandler zweiter Ordnung, dessen Eingang mit dem Ausgang des analogen Schleifenfilters (22) verbunden ist, und vorzugsweise

    weiterhin folgendes umfasst:

    - eine Digital-Analog-Gegenkopplungsverbindung (26), die geeignet ist, das Ausgangssignal des ersten Analog-Digital-Wandlers (24) zurückzuführen, um mit dem zurückgeführten Ausgangssignal (36) der Schaltendstufe (16) kombiniert zu werden, und
    - einen Digital-Analog-Wandler (28), der geeignet ist, das zurückgeführte Ausgangssignal des ersten Analog-Digital-Wandlers (24) in ein analoges Signal umzuwandeln.

6. Verstärker (8) nach Anspruch 5, der weiterhin ein digitales Filter (25) umfasst, dessen Eingang mit dem Ausgang des ersten Analog-Digital-Wandlers (24) verbunden ist, wobei die Digital-Analog-Gegenkopplungsverbindung (26) geeignet ist, das Ausgangssignal des digitalen Filters (25) zurückzuführen, um mit dem zurückgeführten Ausgangssignal (36) der Schaltendstufe (16) kombiniert zu werden.

7. Verstärker (8) nach einem der vorhergehenden Ansprüche, bei dem die Schaltendstufe (16) durch eine H-Brücke gebildet wird und/oder die Schaltmittel durch Power MOSFET-Transistoren gebildet werden, und/oder der weiterhin ein Filter (18) umfasst, dessen Eingang mit dem Ausgang der Schaltendstufe (16) verbunden ist, wobei die Gegenkopplungsverbindung (20) geeignet ist, das Ausgangssignal (36) der Schaltendstufe (16) vor oder nach dem Filter (18) zurückzuführen.

8. Verstärker (8) nach einem der vorhergehenden Ansprüche, der für den Betrieb mit einer Versorgungsspannung (30) eingerichtet ist, die extern angeschlossen wird, und/oder der zusätzlich einen zweiten Analog-Digital-Wandler (32) umfasst, der geeignet ist, die Versorgungsspannung (30) in ein digitales Signal umzuwandeln und dieses an die Kompensationsmittel (52) weiterzuleiten.

9. Verstärker (8) nach einem der Ansprüche 5 bis 8, der zusätzlich eine Taktquelle (40) zur digitalen Signalverarbeitung und/oder zur digitalen Signalerzeugung umfasst, wobei der erste Analog-Digital-Wandler (24) für den Betrieb mit einer Abtastfrequenz eingerichtet ist, die $\geq$ 100 kHz, vorzugsweise $\geq$ 1 MHz, besonders vorzugsweise $\geq$ 10 MHz ist.

10. Verstärker (8) zur Verstärkung eines Eingangssignals zu einem Ausgangssignal (36), der einen Signalpfad (10) und eine Gegenkopplungsverbindung (20) umfasst, wobei der Signalpfad (10)

    - Modulationsmittel (14) umfasst, die geeignet sind, das Eingangssignal zu empfangen und in Antwort auf das empfangene Eingangssignal ein Schaltsignal zu erzeugen, und
    - eine Schaltendstufe (16) umfasst, die mit einer Versorgungsspannung (30) verbunden ist, wobei die Schaltendstufe (16) Schaltmittel umfasst, die entsprechend dem von den Modulationsmitteln (14) erzeugten Schaltsignal geschaltet werden, und die Schaltendstufe (16) ein Ausgangssignal (36) erzeugt, dessen Amplitude von der Versorgungsspannung (30) abhängt,

    und wobei die Gegenkopplungsverbindung (20) geeignet ist, das Ausgangssignal (36) der Schaltendstufe (16) zurückzuführen, um mit dem Eingangssignal kombiniert zu werden, wobei der Signalpfad (10) und die Gegenkopplungsverbindung (20) eine Schleife (42) mit einer Schleifenverstärkung bilden, der Verstärker Kompensationsmittel (52) umfasst, welche die Versorgungsspannung (30) der Schaltendstufe (16) oder ein aus dieser abgeleitetes Signal empfangen, und die geeignet sind, Änderungen in der Schleifenverstärkung, die sich aufgrund einer Variation der Versorgungsspannung (30) ergeben, zumindest teilweise zu kompensieren, **dadurch gekennzeichnet, dass** die Kompensationsmittel (52) geeignet sind, durch ein Eingreifen in den Signalpfadabschnitt innerhalb der Schleife (42) eine Verstärkung bzw. eine Verringerung des Signals in dem Signalpfadabschnitt innerhalb der Schleife (42) in Abhängigkeit der Versorgungsspannung (30) in einer Weise vorzunehmen, die einer Änderung der Schleifenverstärkung aufgrund der Variation der Versorgungsspannung (30) entgegenwirkt, die Kompensationsmittel geeignet sind, das Signal auf dem Signalpfad (10) mit der Versorgungsspannung (30) der Schaltendstufe (16) oder mit einem aus diesem abgeleiteten Signal zu dividieren.

11. Verstärker (8) nach einem der vorhergehenden Ansprüche, der weiterhin Mittel zum Variieren der Versorgungsspannung (30) in Abhängigkeit von dem Eingangssignal umfasst.

12. Verfahren zur Verstärkung eines Eingangssignals zu einem Ausgangssignal (36) mithilfe eines Verstärkers (8), der einen Signalpfad (10) und eine Gegenkopplungsverbindung (20) umfasst, die eine Schleife (42) mit einer Schleifenverstärkung bilden, wobei das Verfahren die folgenden Schritte umfasst:

- Empfangen des Eingangssignals,
- Erzeugen eines Schaltsignals mithilfe von Modulationsmitteln (14),
- Erzeugen eines Ausgangssignals (36) mithilfe einer Schaltendstufe (16), die mit einer Versorgungsspannung (30) verbunden ist, wobei die Schaltendstufe (16) Schaltmittel enthält, die entsprechend dem von den Modulationsmitteln (14) erzeugten Schaltsignal geschaltet werden, wobei die Amplitude des Ausgangssignals (36) von der Versorgungsspannung (30) abhängt,
- Zurückführen des Ausgangssignals (36) der Schaltendstufe (16) mithilfe der Gegenkopplungsverbindung (20),
- Kombinieren des zurückgeführten Ausgangssignals (36) mit dem Eingangssignal,

wobei das Verfahren folgende Schritte umfasst:

- zumindest teilweises Kompensieren von Änderungen in der Schleifenverstärkung, die sich aufgrund einer Variation der Versorgungsspannung (30) ergeben, unter Verwendung von Kompensationsmitteln (52), wobei die Kompensationsmittel (52) die Versorgungsspannung (30) der Schaltendstufe (16) oder ein aus dieser abgeleitetes Signal empfangen

**dadurch gekennzeichnet, dass**
die Kompensationsmittel (52) in den Signalpfadabschnitt innerhalb der Schleife (42) eingreifen und dadurch eine Verstärkung bzw. eine Verringerung des Signals in dem Signalpfadabschnitt innerhalb der Schleife (42) in Abhängigkeit der Versorgungsspannung (30) derart vornehmen, dass einer Änderung der Schleifenverstärkung aufgrund der Variation der Versorgungsspannung (30) entgegengewirkt wird,
durch eine Modulator-Gegenkopplungsverbindung (50) des Verstärkers das Schaltsignal an einen Eingang der Modulationsmittel (14) zurückgeführt wird und mit dem Signal am Eingang der Modulationsmittel (14) kombiniert wird, und dass
die Kompensationsmittel (52) das Signal auf der Modulator-Gegenkopplungsverbindung (50) in Abhängigkeit der Versorgungsspannung (30) derart verstärken bzw. verringern, dass einer Änderung der Schleifenverstärkung aufgrund der Variation der Versorgungsspannung (30) entgegengewirkt wird.

13. Verfahren nach Anspruch 12, das einen Verstärker (8) nach einem der Ansprüche 1 bis 9 oder 11 verwendet.

14. Verfahren zur Verstärkung eines Eingangssignals zu einem Ausgangssignal (36) mithilfe eines Verstärkers (8), der einen Signalpfad (10) und eine Gegenkopplungsverbindung (20) umfasst, die eine Schleife (42) mit einer Schleifenverstärkung bilden, wobei das Verfahren die folgenden Schritte umfasst:

- Empfangen des Eingangssignals,
- Erzeugen eines Schaltsignals mithilfe von Modulationsmitteln (14),
- Erzeugen eines Ausgangssignals (36) mithilfe einer Schaltendstufe (16), die mit einer Versorgungsspannung (30) verbunden ist, wobei die Schaltendstufe (16) Schaltmittel enthält, die entsprechend dem von den Modulationsmitteln (14) erzeugten Schaltsignal geschaltet werden, wobei die Amplitude des Ausgangssignals (36) von der Versorgungsspannung (30) abhängt,
- Zurückführen des Ausgangssignals (36) der Schaltendstufe (16) mithilfe der Gegenkopplungsverbindung (20),
- Kombinieren des zurückgeführten Ausgangssignals (36) mit dem Eingangssignal,

wobei das Verfahren folgende Schritte umfasst:

- zumindest teilweises Kompensieren von Änderungen in der Schleifenverstärkung, die sich aufgrund einer Variation der Versorgungsspannung (30) ergeben, unter Verwendung von Kompensationsmitteln (52), wobei die Kompensationsmittel (52) die Versorgungsspannung (30) der Schaltendstufe (16) oder ein aus dieser abgeleitetes Signal empfangen

**dadurch gekennzeichnet, dass**
wobei die Kompensationsmittel (52) in den Signalpfadabschnitt innerhalb der Schleife (42) eingreifen und dadurch eine Verstärkung bzw. eine Verringerung des Signals in dem Signalpfadabschnitt innerhalb der Schleife (42) in Abhängigkeit der Versorgungsspannung (30) derart vornehmen, dass einer Änderung der Schleifenverstärkung aufgrund der Variation der Versorgungsspannung (30) entgegengewirkt wird, die Kompensationsmittel das Signal auf dem Signalpfad (10) mit der Versorgungsspannung (30) der Schaltendstufe (16) oder mit einem aus diesem abgeleiteten Signal dividieren.

15. Verfahren nach Anspruch 14, das einen Verstärker (8) nach Anspruch 10 oder 11 verwendet.

**Claims**

1. Amplifier (8) for amplifying an input signal to form an output signal (36),
which comprises a signal path (10) and a feedback connection (20), wherein the signal path (10)

- comprises modulation means (14), which are suitable for receiving the input signal and in response to the received input signal for generating a switching signal, and
- a switching end stage (16), which is connected to a supply voltage (30), wherein the switching end stage (16) comprises switching means that are switched in accordance with the switching signal generated by the modulation means (14) and the switching end stage (16) generates an output signal (36), the amplitude of which depends on the supply voltage (30),

and wherein the feedback link (20) is suitable for feeding back the output signal (36) to the switching end stage (16) in order to be combined with the input signal,
wherein the signal path (10) and the feedback link (20) form a loop (42) having a loop gain,
wherein the amplifier comprises compensation means (52), which receive the supply voltage (30) of the switching end stage (16) or a signal derived therefrom, and which are suitable for at least partially compensating for changes in the loop gain that arise due to a variation in the supply voltage (30),
**characterized in that**
the compensation means (52) are suitable, by intervention in the signal path section within the loop (42), of performing an amplification or attenuation of the signal in the signal path section within the loop (42) as a function of the supply voltage (30), in such a manner as to counteract a change in the loop gain due to the variation in the supply voltage (30), the amplifier additionally comprises a modulator feedback link (50), which is suitable for feeding back the switching signal to an input of the modulation means (14), in order to be combined with the signal at the input of the modulation means (14), and in the amplifier the compensation means (52) are suitable for amplifying or attenuating the signal on the modulator feedback link (50) as a function of the supply voltage (30), in such a manner as to counteract a change in the loop gain as a result of the variation of the supply voltage (30).

2. Amplifier (8) according to Claim 1,
in which the compensation means (52) are suitable for multiplying the supply voltage (30) of the switching end stage (16), or a signal derived therefrom, by the signal on the modulator feedback link (50), in which preferably the compensation means (52) comprise a multiplexer (52) and in which the supply voltage (30) of the switching end stage (16) or a signal derived therefrom is multiplied by the switching signal by means of the multiplexer (52) in such a way that a signal is formed that at least approximates to the value or the inverted value of the supply voltage (30), or at least approximately has the value or the inverted value of a signal that is derived from the supply voltage (30).

3. Amplifier (8) according to Claim 2,
in which the modulation means (14) comprise a sigma-delta modulator (14), wherein the sigma-delta-modulator (14) preferably comprises a loop filter (44, 46) with two or more integrators, in which the loop filter (44, 46) can preferably assume states which are influenced by at least one state variable, for which the loop filter (44, 46) has a limiting value (62), wherein the compensation means are suitable for adjusting the limit value (62) accordingly in response to the variation in the supply voltage (30).

4. Amplifier (8) according to Claim 3,
in which the sigma-delta-modulator (14) is implemented on a hardware-programmable component (38), in particular on an FPGA, wherein the amplifier (8) preferably additionally comprises a digital loop filter (12) which is arranged in the signal path (10) before the sigma-delta-modulator (14) and which is suitable for receiving and amplifying the input signal after the latter has been combined with the output signal (36) that is fed back by the feedback link (20), wherein the digital loop filter (12) is implemented on the hardware-programmable component (38), in particular on the FPGA.

5. Amplifier (8) according to Claim 4,
which also comprises the following in the feedback link:

- an analogue loop filter (22), and
- a first analogue-to-digital converter (24), in particular an analogue-to-digital converter of second order, the input of which is connected to the output of the analogue loop filter (22), and preferably also comprises the following:

- a digital-to-analogue feedback link (26), which is suitable for feeding back the output signal of the first analogue-to-digital converter (24), in order to be combined with the fed back output signal (36) of the switching end stage (16), and
- a digital-to-analogue converter (28), which is suitable for converting the fed back output signal of the first analogue-to-digital converter (24) into an analogue signal.

6. Amplifier (8) according to Claim 5,
which additionally comprises a digital filter (25), the input of which is connected to the output of the first analogue-to-digital converter (24), wherein the digital-to-analogue feedback link (26) is suitable for feeding back the output signal of the digital filter (25), in order to be combined with the fed back output signal (36) of the switching end stage (16).

7. Amplifier (8) according to any one of the previous claims,
in which the switching end stage (16) is formed by an H-bridge and/or the switching means are formed by power MOSFET transistors, and/or which further comprises a filter (18), the input of which is connected to the output of the switching end stage (16), wherein the feedback link (20) is suitable for feeding back the output signal (36) of the switching end stage (16) before or after the filter (18).

8. Amplifier (8) according to any one of the previous claims,
which is configured for operation with a supply voltage (30) that is connected externally, and/or which additionally comprises a second analogue-to-digital converter (32) that is suitable for converting the supply voltage (30) into a digital signal and forwarding this to the compensation means (52).

9. Amplifier (8) according to any one of Claims 5 to 8, which additionally comprises a clock source (40) for digital signal processing and/or digital signal generation, wherein the first analogue-to-digital converter (24) is configured for operation with a sampling frequency which is ≥ 100 kHz, preferably ≥ 1 MHz, particularly preferably ≥ 10 MHz.

10. Amplifier (8) for amplifying an input signal to form an output signal (36),
which comprises a signal path (10) and a feedback link (20),
wherein the signal path (10)

 - comprises modulation means (14), which are suitable for receiving the input signal and in response to the received input signal for generating a switching signal, and
 - comprises a switching end stage (16) which is connected to a supply voltage (30), wherein the switching end stage (16) comprises switching means that are switched in accordance with the switching signal generated by the modulation means (14) and the switching end stage (16) generates an output signal (36), the amplitude of which depends on the supply voltage (30),

and wherein the feedback link (20) is suitable for feeding back the output signal (36) to the switching end stage (16) in order to be combined with the input signal,
wherein the signal path (10) and the feedback link (20) form a loop (42) having a loop gain,
the amplifier comprises compensation means (52) which receive the supply voltage (30) of the switching end stage (16) or a signal derived therefrom, and which are suitable for at least partially compensating for changes in the loop gain that arise due to a variation in the supply voltage (30),
**characterized in that**
the compensation means (52) are suitable, by intervention in the signal path section within the loop (42), for performing an amplification or attenuation of the signal in the signal path section within the loop (42) as a function of the supply voltage (30), in such a manner as to counteract a change in the loop gain due to the variation in the supply voltage (30),
the compensation means are suitable for dividing the signal on the signal path (10) by the supply voltage (30) of the switching end stage (16) or by a signal derived therefrom.

11. Amplifier (8) according to any one of the previous claims,
which additionally comprises means for varying the supply voltage (30) as a function of the input signal.

12. Method for amplifying an input signal to form an output signal (36) using an amplifier (8) which comprises a signal path (10) and a feedback link (20) that comprises a loop (42) having a loop gain, wherein the method comprises the following steps:

 - receiving the input signal,
 - generating a switching signal using modulation means (14),
 - generating an output signal (36) using a switching end stage (16), which is connected to a supply voltage (30), wherein the switching end stage (16) contains switching means that are switched in accordance with the switching signal generated by the modulation means (14), the amplitude of the output signal (36) depending on the supply voltage (30),
 - feeding back the output signal (36) of the switching end stage (16) using the feedback link (20),
 - combining the fed back output signal (36) with the input signal,

said method comprising the following steps:

 - at least partially compensating for changes in the loop gain that arise due to a variation in the supply voltage (30), using compensation means (52), wherein the compensation means (52) receive the supply voltage (30) of the switching end stage (16) or a signal derived therefrom;

**characterized in that**

the compensation means (52) intervene in the signal path section within the loop (42), thereby performing an amplification or attenuation of the signal in the signal path section within the loop (42) as a function of the supply voltage (30), in such a manner that a change in the loop gain due to the variation in the supply voltage (30) is counteracted,
**in that** the switching signal of the amplifier is fed back through a modulator feedback link (50) to an input of the modulation means (14) and is combined with the signal at the input of the modulation means (14), and
**in that** the compensation means (52) amplify or attenuate the signal on the modulator feedback link (50) as a function of the supply voltage (30) in such a way that a change in the loop gain as a result of the variation in the supply voltage (30) is counteracted.

13. Method according to Claim 12,
which uses an amplifier (8) according to any of Claims 1 to 9 or 11.

14. Method for amplifying an input signal to form an output signal (36) using an amplifier (8), which comprises a signal path (10) and a feedback link (20) that comprises a loop (42) having a loop gain, wherein the method comprises the following steps:

- receiving the input signal,
- generating a switching signal using modulation means (14),
- generating an output signal using a switching end stage (16), which is connected to a supply voltage (30), wherein the switching end stage (16) contains switching means that are switched in accordance with the switching signal generated by the modulation means (14), the amplitude of the output signal (36) depending on the supply voltage (30),
- feeding back the output signal (36) of the switching end stage (16) using the feedback link (20),
- combining the fed back output signal (36) with the input signal,

said method comprising the following steps:

- at least partially compensating for changes in the loop gain that arise due to a variation in the supply voltage (30), using compensation means (52), wherein the compensation means (52) receive the supply voltage (30) of the switching end stage (16) or a signal derived therefrom

**characterized in that**
the compensation means (52) intervene in the signal path section within the loop (42), thereby performing an amplification or attenuation of the signal in the signal path section within the loop (42) as a function of the supply voltage (30), in such a manner that a change in the loop gain due to the variation in the supply voltage (30) is counteracted, wherein the compensation means divide the signal on the signal path (10) by the supply voltage (30) of the switching end stage (16) or by a signal derived therefrom.

15. Method according to Claim 14,
which uses an amplifier (8) according to Claim 10 or 11.

**Revendications**

1. Amplificateur (8) pour l'amplification d'un signal d'entrée en un signal de sortie (36), qui comprend un trajet de signal (10) et une liaison de contre-couplage (20), le trajet de signal (10)

- comprenant des moyens de modulation (14) qui sont conçus pour recevoir le signal d'entrée et générer un signal de commutation en réponse au signal d'entrée reçu, et
- comprenant un étage final de commutation (16) qui est connecté avec une tension d'alimentation (30), l'étage final de commutation (16) comprenant des moyens de commutation qui sont commutés en fonction du signal de commutation généré par les moyens de modulation (14), et l'étage final de commutation (16) générant un signal de sortie (36) dont l'amplitude dépend de la tension d'alimentation (30),

et la liaison de contre-couplage (20) étant conçue pour réintroduire le signal de sortie (36) dans l'étage final de commutation (16) afin qu'il soit combiné avec le signal d'entrée,
le trajet de signal (10) et la liaison de contre-couplage (20) formant une boucle (42) avec une amplification de boucle,
l'amplificateur comprenant des moyens de compensation (52) qui reçoivent la tension d'alimentation (30) de l'étage final de commutation (16) ou un signal dérivé de celle-ci et qui sont conçus pour compenser au moins partiellement les modifications de l'amplification de boucle dues à une variation de la tension d'alimentation (30) ;
**caractérisé en ce que**
les moyens de compensation (52) sont conçus pour effectuer, à l'aide d'une intervention dans la portion du trajet de signal à l'intérieur de la boucle (42), une amplification ou une réduction du signal dans la portion du trajet de signal à l'intérieur de la boucle (42) en fonction de la tension d'alimentation (30) de façon à contrer une modification de l'amplification de boucle due à la variation de tension d'alimentation (30),

l'amplificateur comprend en outre une liaison de contre-couplage de modulateur (50) qui est conçue pour réintroduire le signal de commutation au niveau d'une entrée des moyens de modulation (14), afin qu'il soit combiné avec le signal à l'entrée des moyens de modulation (14) et
dans l'amplificateur, les moyens de compensation (52) sont conçus pour amplifier ou pour réduire le signal sur la liaison de contre-couplage de modulateur (50) en fonction de la tension d'alimentation (30) de façon à contrer une modification de l'amplification de boucle due à la variation de la tension d'alimentation (30).

**2.** Amplificateur (8) selon la revendication 1, dans lequel les moyens de compensation (52) sont conçus pour multiplier la tension d'alimentation (30) de l'étage final de commutation (16) ou un signal dérivé de celle-ci avec le signal sur la liaison de contre-couplage de modulateur (50), dans lequel, de préférence, les moyens de compensation (52) comprennent un multiplexeur (52) et dans lequel la tension d'alimentation (30) de l'étage final de commutation (16) ou un signal dérivé de celle-ci est multiplié par le multiplexeur (52) avec le signal de commutation de façon à ce qu'un signal soit généré, qui présente au moins approximativement la valeur ou l'inverse de la valeur de la tension d'alimentation (30) ou au moins approximativement la valeur ou l'inverse de la valeur d'un signal qui est dérivé de la tension d'alimentation (30).

**3.** Amplificateur (8) selon la revendication 2, dans lequel les moyens de modulation (14) comprennent un modulateur sigma-delta (14), le modulateur sigma-delta (14) comprenant de préférence un filtre de boucle (44, 46) avec deux intégrateurs ou plus, dans lequel, de préférence, le filtre de boucle (44, 46) peut adopter des états qui sont influencés par au moins une variable d'état, pour laquelle la boucle de filtre (44, 46) présente une valeur de limitation (62), les moyens de compensation étant conçus pour adapter la valeur de limitation (62) en réponse à la variation de la tension d'alimentation (30).

**4.** Amplificateur (8) selon la revendication 3, dans lequel le modulateur sigma-delta (14) est réalisé sur un composant matériel programmable (38), plus particulièrement sur un FPGA, de préférence l'amplificateur (8) comprenant en outre un filtre de boucle numérique (12) qui est disposé dans le trajet de signal (10) avant le modulateur sigma-delta (14) et qui est conçu pour recevoir le signal d'entrée et l'amplifier une fois que celui-ci ait été combiné avec le signal de sortie (36) réintroduit par la liaison de contre-couplage (20), le filtre de boucle numérique (12) étant réalisé sur le composant matériel programmable (38), plus particulièrement sur le FPGA.

**5.** Amplificateur (8) selon la revendication 4, qui comprend, en outre, dans la liaison de contre-couplage, ce qui suit :

- un filtre de boucle numérique (22) et
- un premier convertisseur analogique-numérique (24), plus particulièrement un convertisseur analogique-numérique de deuxième ordre, dont l'entrée est connectée à la sortie du filtre de boucle analogique (22) et de préférence comprend en outre ce qui suit :

- une liaison de contre-couplage numérique-analogique (26) qui est conçue pour réintroduire le signal de sortie du premier convertisseur analogique-numérique (24), afin qu'il soit combiné avec le signal de sortie (36) réintroduit de l'étage final de commutation (16) et
- un convertisseur numérique-analogique (28) qui est conçu pour convertir le signal de sortie réintroduit du premier convertisseur analogique-numérique (24) en un signal analogique.

**6.** Amplificateur (8) selon la revendication 5, qui comprend en outre un filtre numérique (25) dont l'entrée est connectée à la sortie du premier convertisseur analogique-numérique (24), la liaison de contre-couplage numérique-analogique (26) étant conçue pour réintroduire le signal de sortie du filtre numérique (25) afin qu'il soit combiné avec le signal de sortie (36) réintroduit de l'étage de final de commutation (16).

**7.** Amplificateur (8) selon l'une des revendications précédentes, dans lequel l'étage final de commutation (16) est constitué d'un pont en forme de H et/ou les moyens de commutation sont constitués de transistors de puissance MOSFET et/ou qui comprend en outre un filtre (18) dont l'entrée est connectée à la sortie de l'étage final de commutation (16), la liaison de contre-couplage (20) étant conçue pour réintroduire le signal de sortie (36) de l'étage final de commutation (16) avant ou après le filtre (18).

**8.** Amplificateur (8) selon l'une des revendications précédentes, qui est conçu pour fonctionner avec une tension d'alimentation (30) qui est branchée en externe et/ou qui comprend en outre un deuxième convertisseur analogique-numérique (32) qui est conçu pour convertir la tension d'alimentation (30) en un signal numérique et la transmettre aux moyens de compensation (52).

**9.** Amplificateur (8) selon l'une des revendications 5 à 8, qui comprend en outre une source de signal d'horloge (40) pour le traitement numérique de signaux et/ou pour la génération de signaux numériques, le premier convertisseur analogique-numérique (24) étant conçu pour fonctionner avec une fréquence de balayage ≥ 100 kHz, de préférence ≥ 1 MHz, plus particulièrement de préférence ≥ 10 MHz.

10. Amplificateur (8) pour l'amplification d'un signal d'entrée en un signal de sortie (36), qui comprenant un trajet de signal (10) et une liaison de contre-couplage (20), le trajet de signal (10)

   - comprenant des moyens de modulation (14) qui sont conçus pour recevoir le signal d'entrée et générer un signal de commutation en réponse au signal d'entrée reçu, et
   - comprenant un étage final de commutation (16) qui est connecté avec une tension d'alimentation (30), l'étage final de commutation (16) comprenant des moyens de commutation qui sont commutés en fonction du signal de commutation généré par les moyens de modulation (14), et l'étage final de commutation (16) générant un signal de sortie (36) dont l'amplitude dépend de la tension d'alimentation (30),

   et la liaison de contre-couplage (20) étant conçue pour réintroduire le signal de sortie (36) dans l'étage final de commutation (16) afin qu'il soit combiné avec le signal d'entrée,
   le trajet de signal (10) et la liaison de contre-couplage (20) formant une boucle (42) avec une amplification de boucle,
   l'amplificateur comprenant des moyens de compensation (52) qui reçoivent la tension d'alimentation (30) de l'étage final de commutation (16) ou un signal dérivé de celle-ci et qui sont conçus pour compenser au moins partiellement les modifications de l'amplification de boucle dues à une variation de la tension d'alimentation (30),
   **caractérisé en ce que**
   les moyens de compensation (52) sont conçus pour effectuer, à l'aide d'une intervention dans la portion du trajet de signal à l'intérieur de la boucle (42), une amplification ou une réduction du signal dans la portion du trajet de signal à l'intérieur de la boucle (42) en fonction de la tension d'alimentation (30) de façon à contrer une modification de l'amplification de boucle due à la variation de tension d'alimentation (30), les moyens de compensation sont conçus pour diviser le signal sur le trajet de signal (10) avec la tension d'alimentation (30) de l'étage final de commutation (16) ou avec un signal dérivé de celle-ci.

11. Amplificateur (8) selon l'une des revendications précédentes, qui comprend en outre des moyens permettant de faire varier la tension d'alimentation (30) en fonction du signal d'entrée.

12. Procédé d'amplification d'un signal d'entrée en un signal de sortie (36) au moyen d'un amplificateur (8) qui comprend un trajet de signal (10) et une liaison de contre-couplage (20), qui forment une boucle (42) avec une amplification de boucle, ce procédé comprenant les étapes suivantes :

   - réception du signal d'entrée,
   - génération d'un signal de commutation à l'aide de moyens de modulation (14),
   - génération d'un signal de sortie (36) à l'aide d'un étage final de commutation (16) qui est connecté avec une tension d'alimentation (30), l'étage final de commutation (16) comprenant des moyens de commutation qui sont commutés en fonction du signal de commutation généré par les moyens de modulation (14), l'amplitude du signal de sortie (36) dépendant de la tension d'alimentation (30),
   - réintroduction du signal de sortie (36) de l'étage final de commutation (16) à l'aide de la liaison de contre-couplage (20),
   - combinaison du signal de sortie réintroduit (36) avec le signal d'entrée,

   le procédé comprenant les étapes suivantes :

   - compensation au moins partielle des modifications de l'amplification de boucle dues à une variation de la tension d'alimentation (30), à l'aide de moyens de compensation (52), les moyens de compensation (52) recevant la tension d'alimentation (30) de l'étage final de commutation (16) ou un signal dérivé de celle-ci

   **caractérisé en ce que**
   les moyens de compensation (52) interviennent dans la portion du trajet de signal à l'intérieur de la boucle (42) et effectuent ainsi une amplification ou une réduction du signal dans la portion du trajet de signal à l'intérieur de la boucle (42) en fonction de la tension d'alimentation (30) de façon à contrer une modification de l'amplification de boucle due à la variation de la tension d'alimentation (30),
   une liaison de contre-couplage de modulateur (50) de l'amplificateur permet de réintroduire le signal de commutation au niveau de l'entrée des moyens de modulation (14) et de le combiner avec le signal à l'entrée des moyens de modulation (14) et **en ce que** les moyens de compensation (52) amplifient ou réduisent le signal sur la liaison de contre-couplage de modulateur (50) en fonction de la tension d'alimentation (30) de façon à contrer une modification de l'amplification de boucle due à la variation de la tension d'alimentation (30).

13. Procédé selon la revendication 12, qui utilise un amplificateur (8) selon l'une des revendications 1 à 9 ou 11.

14. Procédé d'amplification d'un signal d'entrée en un signal de sortie (36) à l'aide d'un amplificateur (8), qui comprend un trajet de signal (10) et une liaison de contre-couplage (20), qui forment une boucle (42) avec une amplification de boucle, le procédé comprenant les étapes suivantes :

- réception du signal d'entrée,
- génération d'un signal de commutation à l'aide de moyens de modulation (14),
- génération d'un signal de sortie (36) à l'aide d'un étage final de commutation (16), qui est connecté avec une tension d'alimentation (30), l'étage final de commutation (16) comprenant des moyens de commutation qui sont commutés en fonction du signal de commutation généré par les moyens de modulation (14), l'amplitude du signal de sortie (36) dépendant de la tension d'alimentation (30),
- réintroduction du signal de sortie (36) de l'étage final de commutation (16) à l'aide de la liaison de contre-couplage (20),
- combinaison du signal de sortie réintroduit (36) avec le signal d'entrée,

le procédé comprenant les étapes suivantes :

- compensation au moins partielle des modifications de l'amplification de boucle due à une variation de la tension d'alimentation (30), à l'aide de moyens de compensation (52), les moyens de compensation (52) recevant la tension d'alimentation (30) de l'étage final de commutation (16) ou un signal dérivé de celle-ci

**caractérisé en ce que**
les moyens de compensation (52) interviennent dans la portion de trajet de signal à l'intérieur de la boucle (42) et effectuent une amplification ou une réduction du signal dans la portion de trajet de signal à l'intérieur de la boucle (42) en fonction de la tension d'alimentation (30) de façon à contrer une modification de l'amplification de boucle due à la variation de la tension d'alimentation (30), les moyens de compensation divisent le signal sur le trajet de signal (10) avec la tension d'alimentation (30) de l'étage final de commutation (16) ou avec un signal dérivé de celle-ci.

15. Procédé selon la revendication 14, qui utilise un amplificateur (8) selon la revendication 10 ou 11.

Fig. 1

Fig. 2

**Fig. 3**

EP 2 856 642 B1

**IN DER BESCHREIBUNG AUFGEFÜHRTE DOKUMENTE**

**In der Beschreibung aufgeführte Patentdokumente**

- US 20080042746 A1
- US 20060091945 A1
- EP 0503571 A1
- US 2007152750 A1